# EUROPEAN PATENT SPECIFICATION

(11) **EP 0 280 318 B1**
(45) Date of publication and mention of the grant of the patent: **02.07.1997**
(21) Application number: 88102893.0
(22) Date of filing: 26.02.1988
(51) Int. Cl.: H03G 3/20

(54) **Radio receiver with a received input level monitoring circuit**
Radio-Empfänger mit einer Schaltung zum Überwachen des Eingangsempfangspegels
Récepteur radio comprenant un circuit surveillant le niveau des signaux d'entrée

(43) Date of publication of application: 31.08.1988
(73) Proprietor: NEC CORPORATION, Tokyo (JP)
(72) Inventor: Atsuta, Hirosada c/o NEC Corporation, Minato-ku Tokyo (JP); Fujita, Toshio c/o NEC Corporation, Minato-ku Tokyo (JP); Saito, Masao c/o NEC Corporation, Minato-ku Tokyo (JP)
(74) Representative: VOSSIUS & PARTNER

(56) References cited:
- GB-A- 2 004 428
- US-A- 4 580 287
- US-A- 4 713 620

## Description

The present invention relates to a superheterodyne radio receiver of the type having a plurality of automatic gain control (AGC) circuits and, more particularly, to a received input level monitoring circuit installed in such a receiver for collectively monitoring a plurality of AGC voltages which may be used to monitor a received input level.

A prior art radio receiver of the type described includes a radio frequency (RF) amplifier, a frequency converter, a variable gain intermediate frequency (IF) amplifier, and an AGC circuit associated with the IF amplifier, as described in detail later. To monitor a received input level, such a radio receiver detects an AGC voltage in the AGC circuit by use of a DC voltmeter or the like.

In the prior art received input level monitoring circuit stated above, a single AGC voltage in a single AGC circuit is detected. This brings about a drawback that, in the case of a radio receiver provided with a plurality of variable gain amplifiers for broadening the dynamic range associated with received input levels, a plurality of AGC voltages have to be monitored independently of each other in association with the received input level. The result is complicated monitoring and, therefore, the need for a complicated circuit arrangement.

From GB-A-2 004 428 a receiver circuit arrangement with automatic gain control is known. This known receiver circuit comprises a plurality of cascaded variable gain amplifier means which are controlled independently of each other by a respective automatic gain control means. Dependent on an output of each amplifier means, a respective control signal is produced.

US-A-4,580,287 describes a radio receiver having one or more automatic gain control circuits. In this known embodiment a logarithm circuit is used to detect a total gain of the plurality of amplifiers.

It is, therefore, an object of the present invention to provide a radio receiver having a received input Level monitoring circuit which realizes collective and, therefore, easy monitoring while simplifying the circuit arrangement.

This object is solved by a radio receiver having the features of claim 1.

### BRIEF DESCRIPTION OF THE DRAWINGS

Fig. 1 is a schematic block diagram showing a radio receiver including a prior art received input level monitoring circuit;
Fig. 2 is a schematic block diagram showing a radio receiver including a received input level monitoring circuit in accordance with the present invention;
Fig. 3 is a schematic block diagram representative of a specific construction of an AGC voltage combining circuit as shown in Fig. 2; and
Figs. 4 to 7 are graphs each showing a relationship between a received input and an AGC voltage for explaining the AGC voltage combining circuit of Fig. 3.

### DETAILED DESCRIPTION OF THE INVENTION

To better understand the present invention, a brief reference will be made to a prior art radio receiver.

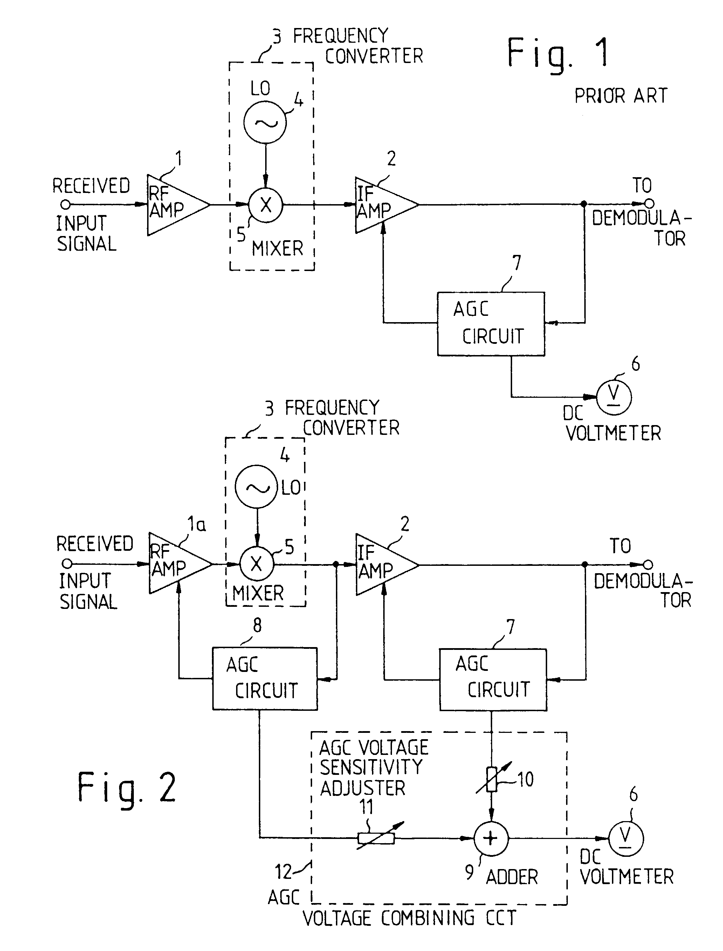

Fig. 1 shows a prior art received input level monitoring circuit installed in a radio receiver. In the figure, an input signal picked up by an antenna, not shown, is amplified by a fixed gain radio frequency (RF) amplifier (RF AMP) 1 and, then, applied to a frequency converter 3. Made up of a local oscillator (LO) 4 and a mixer (MIXER) 5, the frequency converter 3 converts the RF output of the RF amplifier 1 into an intermediate frequency (IF) signal. The IF signal is amplified by a variable gain IF amplifier 2 and, then, fed out to a demodulator, not shown.

In a prior art receiver having the above construction, the received input level is monitored in terms of an AGC voltage in an AGC circuit 7, which is detected by a DC voltmeter 6 or the like. As well known in the art, the AGC circuit 7 is built in the IF amplifier 2 and includes at least a detector and a control signal generator connected to the detector, for example, as well-known.

A drawback with such a prior art implementation in which a single AGC voltage is detected for a single AGC control circuit is as follows. When it comes to a radio receiver provided with a plurality of variable gain amplifiers for broadening the dynamic range for received input levels, a plurality of AGC voltages have to be monitored independently of each other in association with the received input level. This results in multiplicate and intricate monitoring as well as in a complicated circuit arrangement.

A radio receiver in accordance with the present invention which is free from the above drawback will be described.

Referring to Fig. 2, a superheterodyne radio receiver with a received input level monitoring circuit which is representative of one embodiment of the present invention is shown. In Fig. 2, the same or similar structural elements as those shown in Fig. 1 are designated by like reference numerals.

Specifically, Fig. 2 shows a part of the superheterodyne radio receiver, particularly a path for a received input signal coming in through an antenna, not shown, to be propagated toward a demodulator (DEM) by way of an RF-to-IF conversion stage. As shown, the path includes a variable gain RF amplifier 1a for amplifying radio frequency signal, a frequency converter 3 for converting radio frequency to intermediate frequency by means of a local oscillator (LO) and a mixer 5. The path further includes an AGC circuit 8 which automatically controls the gain of the RF amplifier 1a, and another AGC circuit 7 which automatically controls the gain of the IF amplifier 2.

In the above construction, the AGC circuit 8 amplifies a range in which the received input signal level is low to a predetermined level at an RF amplifying stage. Then, the AGC circuit 7 amplifies a range in which the received input signal level is high to a predetermined level at an IF amplifying stage. In this manner, the circuits 8 and 7 serve to broaden the AGC dynamic range.

The AGC circuits 7 and 8 are connected to an adder 9 via, respectively, AGC voltage sensitivity adjusters 10 and 11. The voltages outputted by the circuits 7 and 8 and adjusted individually are added by the adder 9. A DC voltmeter 6 which functions as monitoring means senses an output voltage of the adder 9.

Specifically, the voltage sensitivity adjuster 11 weights the AGC control voltage in the AGC circuit 8 by a predetermined amount while the voltage sensitivity adjuster 10 weights the AGC control voltage in the AGC circuit 7 by a predetermined amount which may be equal to or different from the former. Thereafter, the weighted AGC voltages are added to each other. This produces a composite AGC control voltage as if single AGC voltage control were performed over a broad range of received input levels. By monitoring such an AGC voltage, it is possible to monitor the two independent AGC circuits 7 and 8 collectively.

As stated above, the embodiment shown in Fig. 2 promotes the ease of monitoring and, in addition, eliminates the need for multiple monitoring circuits otherwise associated with the individual AGC circuits to thereby simplify the circuit arrangement.

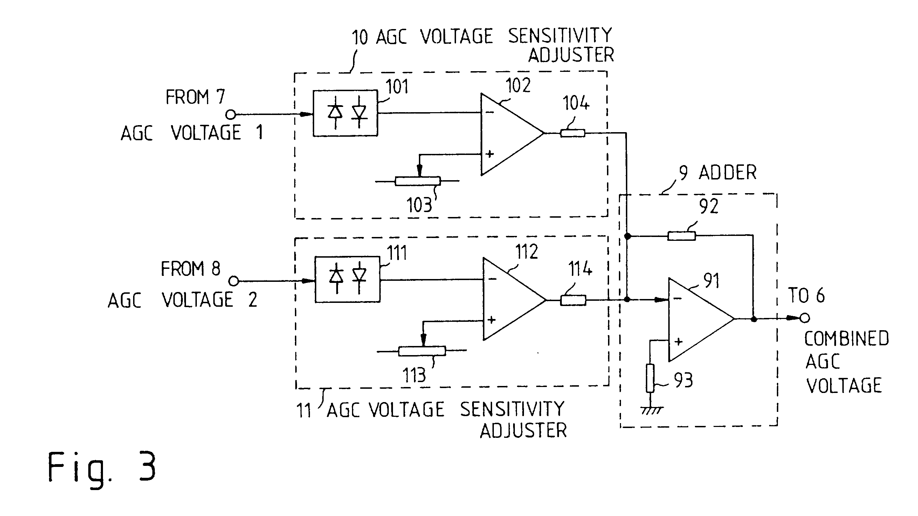

The AGC voltage combination in accordance with the present invention will hereinafter be described in more detail with reference to Figs. 3 to 7.

Referring to Fig. 3, there is shown a specific construction of an AGC voltage combining circuit 12 which is made up of the adder 9 and voltage sensitivity adjusters 10 and 11. As shown, the adder 9 is constituted by a differential amplifier 91 and resistors 92 and 93. The voltage sensitivity adjuster 10 is constituted by a limiter 101, a differential amplifier 102, a resistor 103 for setting a reference voltage, and a resistor 104 for weighting. Further, the voltage sensitivity adjuster 11 is made up of a limiter 111, an operational amplifier 112, a resistor 113 for setting a reference voltage, and a resistor 114 for weighting. The adder 9 and voltage sensitivity adjusters 10 and 11 are individually connected as shown in the figure.

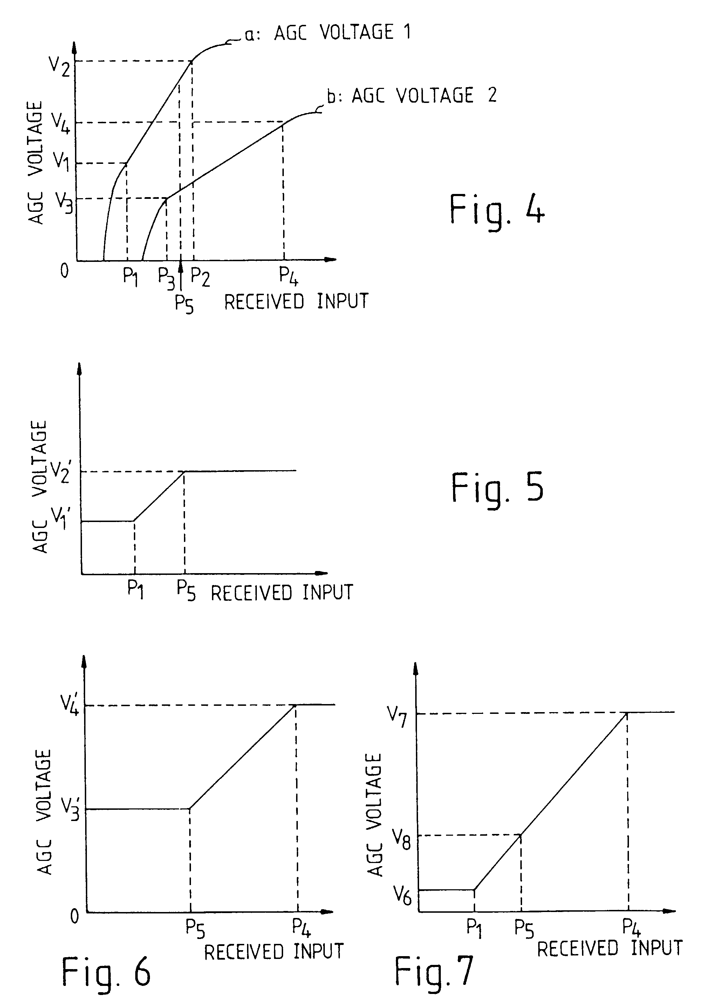

Fig. 4 shows curves representative of the characteristic of AGC voltage 1 of the AGC circuit 7 and that of AGC voltage 2 of the AGC circuit 8, the input levels of the individual AGC amplifiers being plotted in terms of received input of a receiver. Fig. 5 shows an AGC voltage characteristic produced by adjusting the gradient of the AGC voltage 1 relative to the received input to a predetermined value and limiting the ranges of received input other than a monitoring range of P₁ to P₅ to constant values by the limiter 101 (Fig. 3). Fig. 6 shows an AGC voltage characteristic produced by adjusting the gradient of the AGC voltage 1 relative to the received input to a predetermined value and limiting the ranges of received input other than a monitoring range of P₅ to P₄ to predetermined values by the limiter (Fig. 3). Further, Fig. 7 shows a composite AGC voltage characteristic produced by applying the AGC voltages shown in Figs. 5 and 6, which have been adjusted in gradient by, respectively, the limiters 101 and 111 and weighting resistors 104 and 114 (Fig. 3) to predetermined values, to the DC amplifiers 102 and 112 to thereby vary their DC levels such that the adder 9 outputs AGC voltage which varies linearly relative to the monitoring range of P₁ to P₄ of received input.

The AGC voltage combining circuit 12 shown in Fig. 3 combines the AGC voltage 1 of the AGC circuit 7 and the AGC voltage 2 of the AGC circuit 8 each having a particular characteristic as shown in Fig. 4, thereby providing a composite AGC voltage characteristic as shown in Fig. 7. Specifically, the RF amplifier la shown in Fig. 2 uses the linear characteristic of the AGC voltage 1 (V₁ to V₂) in the AGC range (P₁ to P₂) in which the output can be maintained constant relative to the input, as shown in Fig. 4. On the other hand, outside the AGC range (above P₂) of the RF AMP la, the RF amplifier la uses the linear characteristic of the AGC voltage (V₃ to V₄) because AGC of the IF amplifier 2 functions. In this condition, the limiter 101 adjusts the ranges (below P₁ and above P₅) other than the AGC characteristic monitoring range to predetermined values and, then, the DC amplifier 102 and weighting resistor 104 change the gradient and level of the linear portion of the AGC voltage. As a result, AGC voltage which becomes V'₁ in the range below P₁, V'₂ in the range above P₅, and linear in the range of P₁ to P₅ is produced, as shown in Fig. 5. Likewise, the limiter 111 adjusts the ranges (below P₅ and above P₄) other than the AGO characteristic monitoring range to predetermined values and, then, the DC amplifier 112 and weighting circuit 114 change the gradient and level of the linear portion of the AGC voltage. The resulting AGC voltage is V'₃ in the range below P₅, V'₄ in the range above P₄, and linear in the range of P₅ to P₄, as shown in Fig. 6. Adding the AGC voltages shown in Figs. 5 and 6 together, the adder 9 outputs a composite AGC voltage which becomes V₆ in the range below P₁, V₇ in the range above P₄, and linear in the range of P₁ to P₄, as shown in Fig. 7.

While the AGC voltage has been shown and described as being subjected to analog processing to monitor received input, such monitoring may alternatively be implemented with consecutive steps of converting an AGC voltage into a digital value by use of analog-to-digital converter means and processing the digital value by a microcomputer.

## Claims

1. A radio receiver comprising:
a plurality of cascaded variable gain amplifier means (la,2) controlled independently of each other;
a plurality of automatic gain control means (8,7) each being associated with a respective one of said amplifier means to detect an output of said amplifier means and produce a control signal for controlling a gain of said amplifier means ;
characterized by
a plurality of detectors of said respective automatic gain control means for detecting a respective output of said amplifier means
a plurality of voltage adjuster means (11,10) each for adjusting a respective one of said control signals; and
adder means (9) for adding outputs of said voltage adjuster means;
a received input of said receiver being monitored in terms of an output of said adder means; and
said plurality of voltage adjuster means (11,10) include gradient-and-level adjusters (102,104,112,114) for adjusting gradient and level of linear portions of said control signals,respectively,such that said adder means (9) provides a widened monitoring range by combining the adjusted linear portions.

2. A radio receiver as claimed in claim 1, wherein said plurality of voltage adjuster means (11,10) further include limiters (101,111) for limiting ranges of the received input other than monitoring ranges to predetermined constant values, respectively, combination of said monitoring ranges forming said widened monitoring range.

## Patentansprüche

1. Radioempfänger mit:
mehreren kaskadierten Regelverstärkereinrichtungen (1a, 2), die voneinander unabhängig geregelt werden;
mehreren Verstärkungsregelungseinrichtungen (8, 7), wobei jede einer jeweiligen der Verstärkereinrichtungen zugeordnet ist, um ein Ausgangssignal der Verstärkereinrichtung zu ermitteln und ein Steuersignal zum Regeln einer Verstärkung der Verstärkereinrichtung zu erzeugen; gekennzeichnet durch
mehrere Detektoren der jeweiligen Verstärkungsregelungseinrichtungen zum Ermitteln eines jeweiligen Ausgangssignals der Verstärkereinrichtungen;
mehrere Spannungseinstellereinrichtungen (11, 10) jeweils zum Einstellen eines jeweiligen der Steuersignale; und
eine Addierereinrichtung (9) zum Addieren von Ausgangssignalen der Spannungseinstellereinrichtungen;
wobei ein empfangenes Eingangssignal des Empfängers in bezug auf ein Ausgangssignal der Addierereinrichtung überwacht wird; und
die mehreren Spannungseinstellereinrichtungen (11, 10) Steilheit- und Pegeleinsteller (102, 104, 112, 114) aufweisen, zum jeweiligen Einstellen der Steilheit bzw. des Pegels von linearen Abschnitten der Steuersignale, so daß die Addierereinrichtung (9) durch Kombinieren der eingestellten linearen Abschnitte einen verbreiterten Überwachungsbereich bereitstellt.

2. Radioempfänger nach Anspruch 1, wobei die mehreren Spannungseinstellereinrichtungen (11, 10) ferner Begrenzer (101, 111) aufweisen, zum Begrenzen von jeweiligen Bereichen des empfangenen Eingangssignals, aber nicht von Überwachungsbereichen auf vorbestimmte konstante Werte, wobei ein Kombinieren den verbreiterten Überwachungsbereich bildet.

## Revendications

1. Récepteur radio comprenant :
une pluralité de moyens formant amplificateur à gain variable en cascade (1a, 2) commandés indépendamment les uns des autres ;
une pluralité de moyens de contrôle automatique de gain (8, 7), chacun étant associé à un moyen respectif parmi lesdits moyens formant amplificateur afin de détecter une sortie desdits moyens formant amplificateur et produire un signal de contrôle pour contrôler un gain desdits moyens formant amplificateur,
caractérisé par
une pluralité de détecteurs desdits moyens de contrôle automatique de gain respectifs afin de détecter une sortie respective desdits moyens formant amplificateur
une pluralité de moyens de réglage de tension (11, 10), chacun permettant de régler un signal respectif parmi lesdits signaux de contrôle ; et
des moyens formant additionneur (9) permettant d'additionner des sorties desdits moyens de réglage de tension ;
une entrée reçue dudit récepteur étant contrôlée par une sortie desdits moyens formant additionneur ; et
ladite pluralité de moyens de réglage de tension (11, 10) comprend des dispositifs de réglage à gradients et niveaux (102, 104, 112, 114) permettant de régler le gradient et le niveau des parties linéaires desdits signaux de commande respectivement de telle sorte que lesdits moyens formant additionneur (9) délivrent une gamme de contrôle élargie en combinant les parties linéaires réglées.

2. Récepteur radio selon la revendication 1, dans lequel ladite pluralité de moyens de réglage de tension (11, 10) comprend en outre des limiteurs (101, 111) permettant de limiter des gammes de l'entrée reçue autres que des gammes de contrôle à des valeurs constantes prédéterminées, respectivement, une combinaison desdites gammes de contrôle formant ladite gamme de contrôle élargie.
